# EUROPEAN PATENT APPLICATION

(11) **EP 4 535 951 A1**
(43) Date of publication of application: **09.04.2025**
(21) Application number: 24759039.1
(22) Date of filing: 22.02.2024
(51) Int. Cl.: H05K 7/20

(54) **HEAT DISSIPATION APPARATUS AND ELECTRONIC DEVICE**

(30) Priority: 23.08.2023 CN 202311071083
(71) Applicant: HUAWEI TECHNOLOGIES CO., LTD., Shenzhen, Guangdong 518129 (CN)
(72) Inventor: LIU, Jiaju, Shenzhen, Guangdong 518129 (CN); SHI, Jian, Shenzhen, Guangdong 518129 (CN); NIU, Chenji, Shenzhen, Guangdong 518129 (CN); ZOU, Liujun, Shenzhen, Guangdong 518129 (CN)
(74) Representative: Körber, Martin Hans
(86) International application number: PCT/CN2024/078196
(87) International publication number: WO 2025/039491

(57) **Abstract**

This application provides a heat dissipation apparatus and an electronic device. The heat dissipation apparatus includes a housing and a heat dissipation assembly. The housing has a first side and a second side that face away from each other, and the heat dissipation assembly is disposed close to the first side. The housing is provided with an air intake vent and an air exhaust vent, and the air intake vent is provided close to the second side. An opening direction of the air intake vent is not perpendicular to a second side surface, and an opening direction of the air exhaust vent is not perpendicular to the second side surface. The heat dissipation assembly communicates with the air intake vent and the air exhaust vent, and the heat dissipation assembly is configured to perform heat transfer with a heat source component. In the electronic device in this application, the housing may be used as a backplane of the electronic device. The air intake vent and the air exhaust vent may be at least partially hidden from a field of view of a user. This helps improve aesthetics of the electronic device. In addition, when the electronic device is placed, the second side surface is in contact with a table surface, and the air intake vent and the air exhaust vent are separately at an included angle with the table surface. This can reduce a risk that foreign objects or water drops enter the electronic device from the air intake vent and the air exhaust vent, to improve dustproof and waterproof performance of the electronic device.

## Description

### CROSS-REFERENCE TO RELATED APPLICATIONS

This application claims priority to Chinese Patent Application No. 202311071083.9, filed with the China National Intellectual Property Administration on August 23, 2023 and entitled "HEAT DISSIPATION APPARATUS AND ELECTRONIC DEVICE", which is incorporated herein by reference in its entirety.

### TECHNICAL FIELD

This application relates to the field of electronic device technologies, and in particular, to a heat dissipation apparatus and an electronic device.

### BACKGROUND

In recent years, as functions of an electronic device are continuously enriched, a performance requirement on main components such as a memory and a processor of the electronic device is increasingly high. However, with development of miniaturization of the electronic device, when running speeds of the components such as the memory and the processor are increased, sizes of electronic components inside the electronic device are required to be smaller. Consequently, a layout of these electronic components becomes more compact, and the electronic device generates more heat in a unit area. Therefore, how to effectively dissipate heat for the electronic device is an urgent problem to be resolved.

### SUMMARY

This application provides a heat dissipation apparatus and an electronic device, to implement heat dissipation of the electronic device and improve aesthetics of the electronic device.

According to a first aspect, this application provides a heat dissipation apparatus. The heat dissipation apparatus includes a housing and a heat dissipation assembly, where the housing has a first side and a second side that face away from each other, and the heat dissipation assembly is disposed close to the first side. The housing is provided with an air intake vent and an air exhaust vent, and the air intake vent is provided close to the second side. An opening direction of the air intake vent is not perpendicular to a second side surface, and an opening direction of the air exhaust vent is not perpendicular to the second side surface. The heat dissipation assembly communicates with the air intake vent and the air exhaust vent, and the heat dissipation assembly is configured to perform heat transfer with a heat source component.

When the heat dissipation apparatus is used in an electronic device, the housing may be used as a backplane of the electronic device. When a user visually views the second side surface of the housing, the air intake vent and the air exhaust vent may be at least partially hidden from a field of view of the user. This helps improve aesthetics of the electronic device. In addition, when the electronic device is placed on a table surface, the second side surface of the housing is in contact with the table surface, and an opening surface of the air intake vent and an opening surface of the air exhaust vent are separately at an included angle with the table surface. This can reduce a risk that foreign objects or water drops on the table surface enter the electronic device from the air intake vent and the air exhaust vent, to improve dustproof and waterproof performance of the electronic device.

In an implementation, the opening direction of the air intake vent is parallel to the second side surface, and the opening direction of the air exhaust vent is parallel to the second side surface. That is, both the opening surface of the air intake vent and the opening surface of the air exhaust vent are perpendicular to the second side surface. In this way, the air intake vent and the air exhaust vent are more hidden, and the electronic device is more visually beautiful.

A specific position of the air intake vent may be set by using a decoration member of the housing. The housing may include a housing body and a protruding portion disposed on the housing body. The protruding portion may protrude toward the first side, or the protruding portion may protrude toward the second side. The air intake vent is provided on the protruding portion. In this implementation, the protruding portion may be used as a camera decoration member of the electronic device.

In an implementation, the air exhaust vent may be located on the protruding portion and disposed at an interval from the air exhaust vent.

In another implementation, the housing further includes a middle frame, the middle frame is disposed around a periphery of the housing body and is connected to the housing body, and the air exhaust vent is provided on the middle frame.

In an implementation, the protruding portion covers a projection of the heat dissipation assembly on the housing body in a direction perpendicular to a first side surface. This can reduce, without affecting an air flow rate, space occupied by an air driver and a heat dissipation component in the heat dissipation apparatus, thereby facilitating miniaturization of the heat dissipation apparatus.

When the heat dissipation assembly is specifically disposed, the heat dissipation assembly includes an air guide member, the air driver, and the heat dissipation component. The air guide member includes an air intake passage and an air exhaust passage, and the air driver is located between the air intake passage and the air exhaust passage, and communicates with the air intake passage and the air exhaust passage through the air driver. An end that is of the air intake passage and that is away from the air driver communicates with the air intake vent, and an end that is of the air exhaust passage and that is away from the air driver communicates with the air exhaust vent. One end of the heat dissipation component is located in the air exhaust passage, and the other end is configured to perform heat transfer with the heat source component.

The heat dissipation component may be in contact with the heat source component to directly perform heat transfer. Alternatively, the heat dissipation component may perform heat transfer with the heat source component by using another component. For example, the heat dissipation assembly further includes a thermally conductive component, the heat dissipation component and the heat source component are separately in contact with the thermally conductive component, and heat transfer between the heat dissipation component and the heat source component is implemented by using the thermally conductive component.

The thermally conductive component may be used as a circuit board, the circuit board is located on a side that is of the heat dissipation component and that is away from the air exhaust passage, and the heat source component is fastened on a surface of a side that is of the circuit board and that faces away from the heat dissipation component. In this way, a structure of the heat dissipation apparatus is simplified, thereby facilitating miniaturization of the electronic device.

The thermally conductive component includes one or more of the following: a thermally conductive metal member structure, a vapor chamber structure, a heat pipe structure, a graphite structure, a graphene structure, and a pump-driven liquid cooling structure.

According to a second aspect, this application provides an electronic device. The electronic device includes a screen, a heat source component, and the heat dissipation apparatus according to the first aspect. The screen is located on a first side of the housing, the screen is connected to the housing to form an accommodating cavity, and the heat dissipation assembly and the heat source component are located in the accommodating cavity.

The housing of the electronic device is used as a backplane. When a user visually views the second side surface of the housing, the air intake vent and the air exhaust vent may be at least partially hidden from a field of view of the user. This helps improve aesthetics of the electronic device. In addition, when the electronic device is placed on a table surface, the second side surface of the housing is in contact with the table surface, and the opening surface of the air intake vent and the opening surface of the air exhaust vent are separately at an included angle with the table surface. This can reduce a risk that foreign objects or water drops on the table surface enter the electronic device from the air intake vent and the air exhaust vent, to improve dustproof and waterproof performance of the electronic device.

The protruding portion may alternatively be used as an outer housing of a camera module. Specifically, the housing includes a housing body and a protruding portion disposed on the housing body, and the protruding portion has a camera hole. The electronic device further includes the camera module located in the accommodating cavity. The camera module includes a lens, the lens at least partially extends into the camera hole, and an optical axis of the lens passes through the camera hole.

### BRIEF DESCRIPTION OF DRAWINGS

FIG. 1 is a diagram of an electronic device according to an embodiment of this application;
FIG. 2 is an exploded diagram of the electronic device in FIG. 1;
FIG. 3 is another diagram of an electronic device according to an embodiment of this application;
FIG. 4 is another diagram of an electronic device according to an embodiment of this application;
FIG. 5 is an exploded diagram of the electronic device in FIG. 4;
FIG. 6 is a cross-sectional view of the electronic device in FIG. 1 in an A-A direction;
FIG. 7 is a diagram of a heat dissipation assembly according to an embodiment of this application; and
FIG. 8 is another cross-sectional view of the electronic device in FIG. 1 in an A-A direction.

Reference numerals:
10: electronic device; 11: screen; 12: electronic component;
13: heat dissipation apparatus; 14: circuit board; 121: heat source component;
131: housing; 132: heat dissipation assembly; 1311: air intake vent;
1312: air exhaust vent; 1313: housing body; 1314: protruding portion;
1315: middle frame; 1321: air guide member; 1322: air driver;
1323: heat dissipation component; 1324: thermally conductive component; 13211: air intake passage;
13212: air exhaust passage.

### DESCRIPTION OF EMBODIMENTS

To make objectives, technical solutions, and advantages of this application clearer, the following further describes this application in detail with reference to accompanying drawings.

For ease of understanding a heat dissipation apparatus provided in embodiments of this application, the following describes an application scenario of the heat dissipation apparatus. The heat dissipation apparatus may be used in but is not limited to an electronic device such as a mobile phone, an intelligent wearable device, a tablet computer, or a notebook computer. Specifically, the electronic device includes a screen, a rear housing, and a middle frame disposed between the screen and the rear housing. The screen and the rear housing are separately connected to the middle frame, and enclose an accommodating cavity, where the accommodating cavity is configured to accommodate an electronic component. The electronic component includes but is not limited to a memory, a flash memory, a circuit board, a processor, a chip, a camera module, or the like. When the electronic device runs, some components in the electronic component generate heat and become heat source components. If heat dissipation inside the electronic device is not timely, the electronic component is in a high-temperature state for a long time, and the electronic component is easily damaged, causing a fault in the electronic device.

In a related technology, a plurality of air vents are provided on the rear housing of the electronic device, and a fan is disposed in the accommodating cavity. When the fan runs, the heat in the accommodating cavity may be blown through the air vents, to implement a heat dissipation function. However, the plurality of air vents are directly drilled on the rear housing. When the rear housing of the electronic device is placed on a table surface, some small sundries or water drops on the table surface easily enter the electronic device from the air vents. This affects normal running of the electronic device.

Therefore, this application provides a heat dissipation apparatus and an electronic device, to implement heat dissipation of the electronic device and improve aesthetics of the electronic device.

It should be noted that, terms used in the following embodiments are merely for a purpose of describing specific embodiments, but are not intended to limit this application. Terms "one", "a", "the", "the foregoing", "this", and "the one" of singular forms used in this specification and the appended claims of this application are also intended to include forms such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean reference to a same embodiment. Instead, the statements mean "one or more but not all of embodiments", unless otherwise specifically emphasized in another manner. Terms "include", "comprise", "have", and their variants all mean "include but are not limited to", unless otherwise specifically emphasized in another manner.

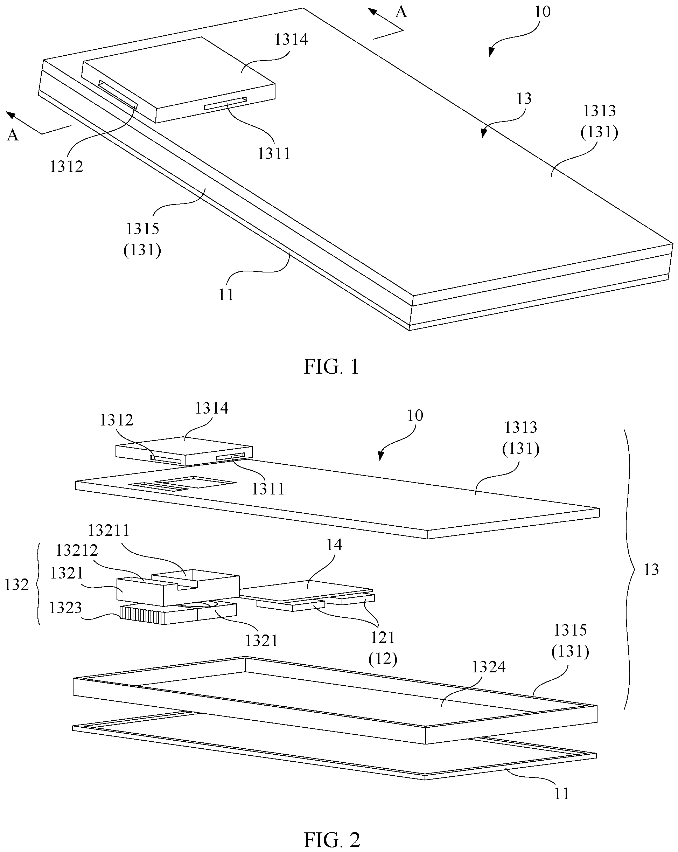

FIG. 1 is a diagram of an electronic device according to an embodiment of this application. FIG. 2 is an exploded diagram of the electronic device in FIG. 1. As shown in FIG. 1 and FIG. 2, the electronic device 10 includes a screen 11, an electronic component 12, and a heat dissipation apparatus 13. The electronic component 12 is located between the screen 11 and the heat dissipation apparatus 13.

It should be noted that, in embodiments of this application, for ease of description, orientation terms such as upper, lower, top, and bottom are introduced. These orientation terms are merely used to more briefly describe and to help a reader locate a described object in a figure, but do not specifically limit a location and a direction of the described object.

When the heat dissipation apparatus 13 is specifically disposed, the heat dissipation apparatus 13 includes a housing 131 and a heat dissipation assembly 132. The housing 131 has a first side and a second side that face away from each other. The first side is a lower side of the housing 131 in FIG. 1 and FIG. 2, and the second side is an upper side of the housing 131 in FIG. 1 and FIG. 2. Therefore, a surface that is of the housing 131 and that faces the first side may be represented as a first side surface, a surface that is of the housing 131 and that faces the second side may be represented as a second side surface (for example, a top surface of the housing in FIG. 1 and FIG. 2), and the first side surface may be parallel to the second side surface. The screen 11 is disposed on the first side of the housing 131, and the screen 11 is connected to the housing 131. In this case, the screen 11 is used as a display surface of the electronic device 10, and the second side surface of the housing 131 is used as an appearance surface of the electronic device 10. When the screen 11 of the electronic device 10 is placed upward on a table surface, the second side surface of the housing 131 may be in contact with the table surface. In addition, the screen 11 and the housing 131 may enclose an accommodating cavity, and the accommodating cavity may accommodate the electronic component 12 and the heat dissipation assembly 132. The housing 131 further has an air intake vent 1311 and an air exhaust vent 1312. The heat dissipation assembly 132 communicates with the air intake vent 1311 and the air exhaust vent 1312, and the heat dissipation assembly 132 is configured to perform heat transfer with a heat source component 121 in the electronic component 12. In this embodiment of this application, an opening direction (namely, an air intake direction) of the air intake vent 1311 is not perpendicular to the second side surface, and an opening direction (namely, an air exhaust direction) of the air exhaust vent 1312 is not perpendicular to the second side surface. In other words, an opening surface (namely, a cross section in a direction perpendicular to the opening direction) of the air intake vent 1311 is disposed at an included angle with the second side surface, and an opening surface (namely, a cross section in a direction perpendicular to the opening direction) of the air exhaust vent 1312 is disposed at an included angle with the second side surface. Therefore, when the electronic device 10 is used, and a user visually views the second side surface of the housing 131, the air intake vent 1311 and the air exhaust vent 1312 may be at least partially hidden from a field of view of the user. This helps improve aesthetics of the electronic device 10. In addition, when the screen 11 of the electronic device 10 is placed upward on the table surface, the second side surface of the housing 131 is in contact with the table surface, and the opening surface of the air intake vent 1311 and the opening surface of the air exhaust vent 1312 are separately at an included angle with the table surface. This can reduce a risk that foreign objects or water drops on the table surface enter the electronic device 10 from the air intake vent 1311 and the air exhaust vent 1312, to improve dustproof and waterproof performance of the electronic device 10.

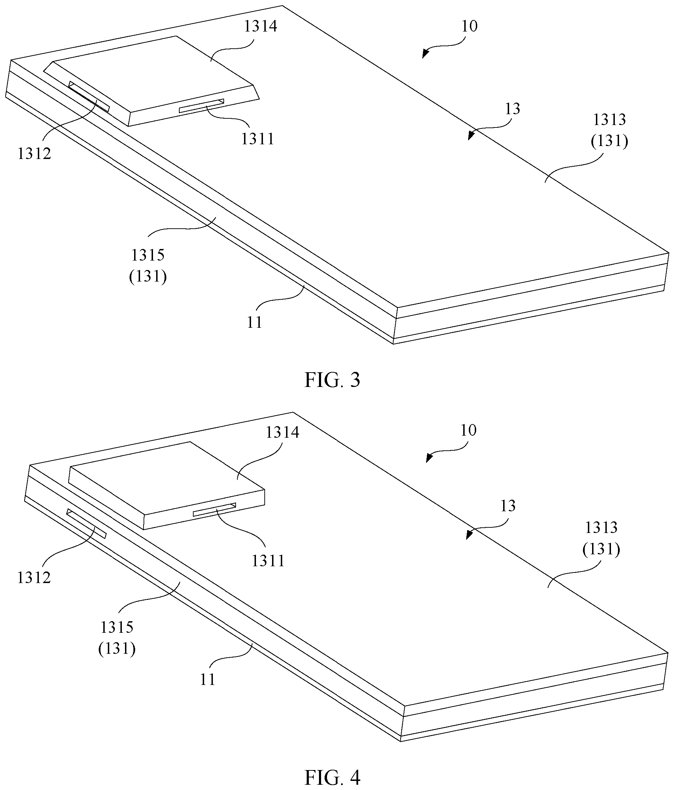

It should be noted that, that the opening direction of the air intake vent 1311 is not perpendicular to the second side surface means that the opening direction of the air intake vent 1311 may be parallel to or may be disposed at an acute angle with the second side surface. Similarly, that the opening direction of the air exhaust vent 1312 is not perpendicular to the second side surface means that the opening direction of the air exhaust vent 1312 may be parallel to or may be disposed at an acute angle with the second side surface. As shown in FIG. 1, in a specific embodiment, the opening direction of the air intake vent 1311 is parallel to the second side surface, and the opening direction of the air exhaust vent 1312 is parallel to the second side surface. In this embodiment, both the opening surface of the air intake vent 1311 and the opening surface of the air exhaust vent 1312 face a side surface of the electronic device 10, to improve aesthetics of the appearance surface of the electronic device 10. FIG. 3 is another diagram of the electronic device according to an embodiment of this application. As shown in FIG. 3, in another specific embodiment, the opening direction of the air intake vent 1311 is disposed at an included angle with the second side surface, and the opening direction of the air exhaust vent 1312 may also be disposed at an included angle with the second side surface. Alternatively, in another specific embodiment, an opening direction of one of the air intake vent 1311 and the air exhaust vent 1312 is parallel to the second side surface, and an opening direction of the other one is disposed at an included angle with the second side surface.

Still refer to FIG. 1 to FIG. 3. When the housing 131 is specifically disposed, the housing 131 may include a housing body 1313 and a protruding portion 1314, where the protruding portion 1314 is disposed on the housing body 1313. As shown in FIG. 1 and FIG. 3, the protruding portion 1314 may be disposed on the second side surface of the housing body 1313. Alternatively, the protruding portion 1314 may be disposed on the first side surface of the housing body 1313, that is, as viewed from the second side of the housing 131, the protruding portion 1314 is a component that is concave toward the first side.

In the foregoing embodiment, the air intake vent 1311 and the air exhaust vent 1312 are provided on a side surface of the protruding portion 1314. Specifically, the air intake vent 1311 and the air exhaust vent 1312 may be provided on different side surfaces of the protruding portion 1314, or may be provided on a same side surface of the protruding portion 1314 at intervals.

In this embodiment of this application, the protruding portion 1314 and the housing body 1313 may be an integrated structure, or the protruding portion 1314 may be connected to the housing body 1313 in a bonding manner. During actual application, the protruding portion 1314 may be used as a camera decoration member of the electronic device 10. Specifically, the electronic device 10 further includes a camera module (not shown in the figure) and a circuit board 14. The electronic component 12 and the camera module are separately electrically connected to the circuit board 14. The camera module is located in the accommodating cavity, and is disposed corresponding to the protruding portion 1314. In this embodiment, the camera module includes a lens, and the protruding portion 1314 is provided with a camera hole. The lens at least partially extends into the camera hole, and an optical axis of the lens passes through the camera hole.

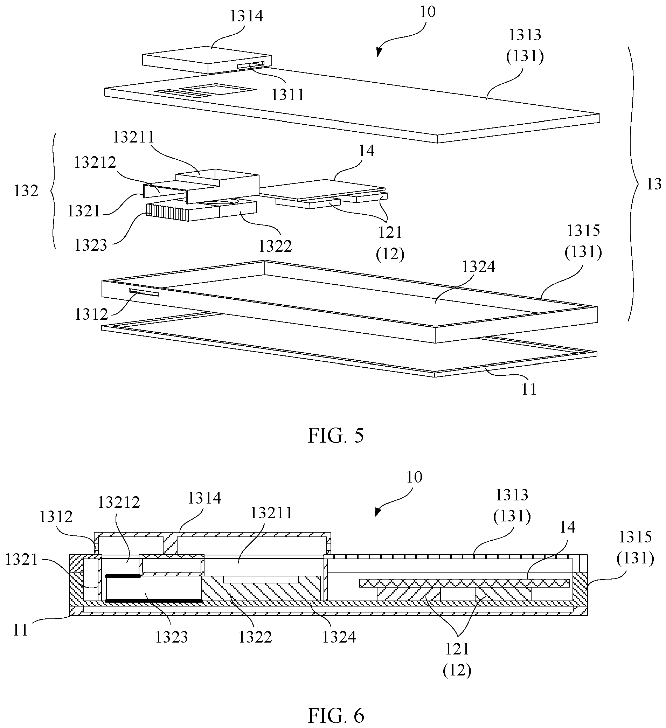

FIG. 4 is another diagram of the electronic device according to an embodiment of this application. FIG. 5 is an exploded diagram of the electronic device in FIG. 4. As shown in FIG. 4 and FIG. 5, in another embodiment, the housing 131 may further include a middle frame 1315. The middle frame 1315 is disposed around a periphery of the housing body 1313 and is located between the screen 11 and the housing body 1313. The screen 11 is connected to the housing body 1313 through the middle frame 1315. That is, the middle frame 1315 forms an appearance side surface of the electronic device 10. In this embodiment, the air intake vent 1311 is disposed on the protruding portion 1314, and the air exhaust vent 1312 may be disposed on the middle frame 1315. In other words, external air enters the heat dissipation assembly 132 from a rear side (namely, the second side) of the electronic device 10, and flows out from the side surface of the electronic device 10.

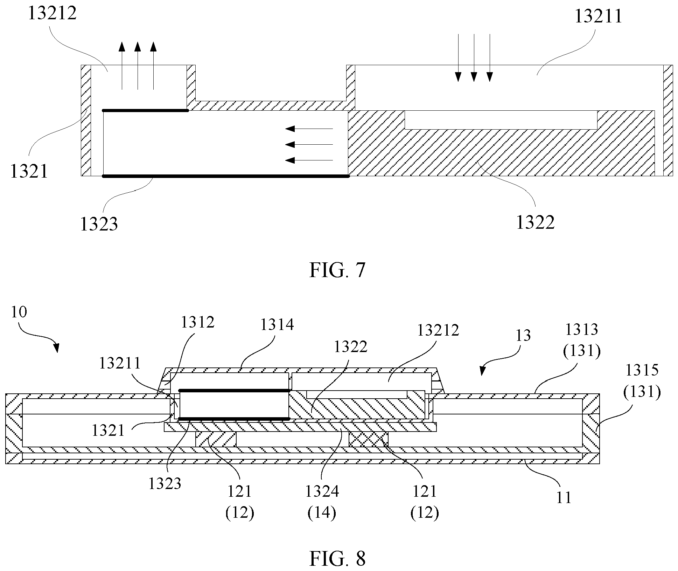

FIG. 6 is a cross-sectional view of the electronic device in FIG. 1 in an A-A direction. FIG. 7 is a diagram of a heat dissipation assembly according to an embodiment of this application. As shown in FIG. 2, FIG. 6, and FIG. 7, the heat dissipation assembly 132 specifically includes an air guide member 1321, an air driver 1322, and a heat dissipation component 1323. Specifically, the air guide member 1321 includes an air intake passage 13211 and an air exhaust passage 13212 that are independent of each other. The air driver 1322 is located between the air intake passage 13211 and the air exhaust passage 13212, and communicates with the air intake passage 13211 and the air exhaust passage 13212 through the air driver 1322. The air driver 1322 provides power for air flow, for example, the air driver 1322 may include a fan or an air pump. An end that is of the air intake passage 13211 and that is away from the air driver 1322 communicates with the air intake vent 1311, and an end that is of the air exhaust passage 13212 and that is away from the air driver 1322 communicates with the air exhaust vent 1312. One end of the heat dissipation component 1323 is located in the air exhaust passage 13212, and the other end is configured to perform heat transfer with the heat source component 121. The heat dissipation component 1323 may include, for example, a plurality of heat sinks. The plurality of heat sinks may be disposed in parallel in a direction parallel to the second side surface, and at least a part of each heat sink extends into the air exhaust passage 13212, so that the heat dissipation component 1323 dissipates heat evenly. When the electronic device 10 is assembled, the heat dissipation component 1323 extends into the air exhaust passage 13212, and the heat dissipation component 1323 and a wall of the air exhaust passage 13212 may be welded, bonded, or connected through a thermal interface material (thermal interface material, TIM). In this way, airtightness of a passage between the air intake vent 1311 and the air exhaust vent 1312 is improved, to improve heat dissipation efficiency.

When the heat dissipation assembly 132 runs, the air driver 1322 is started, so that external air enters the air intake passage 13211 from the air intake vent 1311. After passing through the air driver 1322, the air passes through the air exhaust passage 13212 and is blown out from the air exhaust vent 1312. In this way, a sealed air passage is formed between the air intake vent 1311 and the air exhaust vent 1312, to improve heat dissipation. In this process, the external air sequentially passes through the air intake vent 1311, the air intake passage 13211, the air driver 1322, the air exhaust passage 13212, and the air exhaust vent 1312, to form an airflow used for heat dissipation. When the airflow passes through the air exhaust passage 13212, heat that is of the heat source component 121 and that is transferred to the heat dissipation component 1323 is taken away by the airflow from a surface that is of the heat dissipation component 1323 and that is located in the air exhaust passage 13212, to implement heat dissipation of the heat source component 121.

The protruding portion 1314 may cover projections of the air driver 1322 and the heat dissipation component 1323 on the housing body 1313 in a direction perpendicular to the first side surface. In this way, in a case in which an air flow rate is not affected, space occupied by the air driver 1322 and the heat dissipation component 1323 in the electronic device 10 can be reduced in this design, thereby facilitating miniaturization of the electronic device 10.

In the foregoing embodiment, an end that is of the heat dissipation component 1323 and that is away from the air exhaust passage 13212 may be in contact with the heat source component 121 and directly perform heat transfer. Alternatively, the heat dissipation component 1323 may indirectly perform heat transfer with the heat source component 121 by using another thermally conductive member. For example, the another thermally conductive member may include a thermally conductive component or a shielding can. For example, as shown in FIG. 2 and FIG. 6, in some embodiments, the heat dissipation assembly 132 further includes a thermally conductive component 1324. The heat dissipation component 1323 and the heat source component 121 are separately in contact with the thermally conductive component 1324, and heat transfer between the heat dissipation component 1323 and the heat source component 121 is implemented by using the thermally conductive component 1324. In specific disposition, the thermally conductive component 1324 may be disposed on a side that is of the heat dissipation component 1323 and that faces away from the protruding portion 1314, and the circuit board 14 and the heat source component 121 may be disposed on a side that is of the thermally conductive component 1324 and that faces the heat dissipation component 1323. That is, the air guide member 1321, the air driver 1322, the heat dissipation component 1323, the circuit board 14, and the heat source component 121 are disposed on a side that is of the thermally conductive component 1324 and that faces the housing body 1313, so that a thickness of the electronic device 10 can be reduced. FIG. 8 is another cross-sectional view of the electronic device in FIG. 1 in an A-A direction. As shown in FIG. 8, the circuit board 14 and the heat source component 121, and the air guide member 1321, the air driver 1322, and the heat dissipation component 1323 may alternatively be disposed on different sides of the thermally conductive component 1324. To be specific, the air guide member 1321, the air driver 1322, and the heat dissipation component 1323 are disposed on a side that is of the thermally conductive component 1324 and that faces the housing body 1313, and the circuit board 14 and the heat source component 121 are disposed on a side that is of the thermally conductive component 1324 and that faces away from the housing body 1313. In this way, a width of the electronic device 10 (namely, a size of the electronic device in FIG. 8 in a horizontal direction) can be reduced. In the foregoing embodiment, contact between the thermally conductive component 1324 and the heat dissipation component 1323 may include direct contact or indirect contact. The indirect contact may be a connection between the thermally conductive component 1324 and the heat dissipation component 1323 through welding or a thermal interface material.

Still refer to FIG. 8. In a specific embodiment, the thermally conductive component 1324 may be used as a circuit board 14 while conducting heat. In this embodiment, the thermally conductive component 1324 may include a thermally conductive layer and a circuit unit. The thermally conductive layer may include one or more of the following: a thermally conductive metal layer, a vapor chamber, a heat pipe layer, a graphite layer, a graphene layer, a pump-driven liquid cooling layer, and a thermoelectric cooler (thermoelectric cooler, TEC). The circuit unit may include a multi-layer printed circuit board (printed circuit board, PCB).

The foregoing descriptions are merely specific implementations of this application, but are not intended to limit a protection scope of this application. Any variation or replacement readily figured out by a person skilled in the art within the technical scope disclosed in this application shall fall within the protection scope of this application. Therefore, the protection scope of this application shall be subject to a protection scope of the claims.

## Claims

1. A heat dissipation apparatus, comprising a housing and a heat dissipation assembly, wherein
the housing has a first side and a second side that face away from each other, and the heat dissipation assembly is disposed close to the first side; the housing is provided with an air intake vent and an air exhaust vent, and the air intake vent is provided close to the second side; an opening direction of the air intake vent is not perpendicular to a second side surface, and an opening direction of the air exhaust vent is not perpendicular to the second side surface; and the heat dissipation assembly communicates with the air intake vent and the air exhaust vent, and the heat dissipation assembly is configured to perform heat transfer with a heat source component.

2. The heat dissipation apparatus according to claim 1, wherein the opening direction of the air intake vent is parallel to the second side surface, and the opening direction of the air exhaust vent is parallel to the second side surface.

3. The heat dissipation apparatus according to claim 1 or 2, wherein the housing comprises a housing body and a protruding portion disposed on the housing body;
the protruding portion protrudes toward the first side, or the protruding portion protrudes toward the second side; and
the air intake vent is provided on the protruding portion.

4. The heat dissipation apparatus according to claim 3, wherein the air exhaust vent is located on the protruding portion and is disposed at an interval from the air exhaust vent.

5. The heat dissipation apparatus according to claim 3, wherein the housing further comprises a middle frame, the middle frame is disposed around a periphery of the housing body and is connected to the housing body, and the air exhaust vent is provided on the middle frame.

6. The heat dissipation apparatus according to any one of claims 3 to 5, wherein the protruding portion covers a projection of the heat dissipation assembly on the housing body in a direction perpendicular to a first side surface.

7. The heat dissipation apparatus according to any one of claims 1 to 6, wherein the heat dissipation assembly comprises an air guide member, an air driver, and a heat dissipation component; and
the air guide member comprises an air intake passage and an air exhaust passage, and the air driver is located between the air intake passage and the air exhaust passage, and communicates with the air intake passage and the air exhaust passage through the air driver; an end that is of the air intake passage and that is away from the air driver communicates with the air intake vent, and an end that is of the air exhaust passage and that is away from the air driver communicates with the air exhaust vent; and one end of the heat dissipation component is located in the air exhaust passage, and the other end is configured to perform heat transfer with the heat source component.

8. The heat dissipation apparatus according to claim 7, wherein the heat dissipation assembly further comprises a thermally conductive component, the heat dissipation component and the heat source component are separately in contact with the thermally conductive component, and heat transfer between the heat dissipation component and the heat source component is implemented by using the thermally conductive component.

9. The heat dissipation apparatus according to claim 8, wherein the thermally conductive component is a circuit board, the circuit board is located on a side that is of the heat dissipation component and that is away from the air exhaust passage, and the heat source component is fastened on a surface of a side that is of the circuit board and that faces away from the heat dissipation component.

10. The heat dissipation apparatus according to claim 8 or 9, wherein the thermally conductive component comprises one or more of the following: a thermally conductive metal member structure, a vapor chamber structure, a heat pipe structure, a graphite structure, a graphene structure, and a pump-driven liquid cooling structure.

11. An electronic device, comprising a screen, a heat source component, and the heat dissipation apparatus according to any one of claims 1 to 10, wherein the screen is located on a first side of the housing, the screen is connected to the housing to form an accommodating cavity, and the heat dissipation assembly and the heat source component are located in the accommodating cavity.

12. The electronic device according to claim 11, wherein the housing comprises a housing body and a protruding portion disposed on the housing body, and the protruding portion has a camera hole; and
the electronic device further comprises a camera module located in the accommodating cavity, the camera module comprises a lens, the lens at least partially extends into the camera hole, and an optical axis of the lens passes through the camera hole.
